# EUROPÄISCHE PATENTANMELDUNG

(11) **EP 4 012 927 A1**
(43) Veröffentlichungstag der Anmeldung: **15.06.2022**
(21) Anmeldenummer: 21206866.2
(22) Anmeldetag: 08.11.2021
(51) Int. Cl.: H03K 17/95

(54) **INDUKTIVE SENSOREINRICHTUNG**

(30) Priorität: 09.12.2020 DE 102020215590
(71) Anmelder: Pepperl+Fuchs SE, 68307 Mannheim (DE)
(72) Erfinder: SEEFRIED, Roland, 12277 Berlin (DE)
(74) Vertreter: Fischer, Uwe

(57) **Zusammenfassung**

Die Erfindung bezieht sich unter anderem auf eine induktive Sensoreinrichtung (10) mit einer Messschaltung (20) und zumindest einem an dieser angeschlossenen induktiven Sensorelement (30). Erfindungsgemäß ist vorgesehen, dass das Sensorelement (30) zumindest eine erste Sensorsubeinrichtung (31) und eine zweite Sensorsubeinrichtung (32) umfasst, die Messschaltung (20) zwei oder mehr erste Anschlusskontaktstellen (A11-A12), die untereinander kurzgeschlossen sind, und zwei oder mehr zweite Anschlusskontaktstellen (A21-A24), die untereinander kurzgeschlossen sind, aufweist und die Sensorsubeinrichtungen (31, 32) jeweils einen ersten und einen zweiten Anschluss (31a, 31b, 32a, 32b) aufweisen, mit ihrem ersten Anschluss (31a, 32a) jeweils an eine der ersten Anschlusskontaktstellen (A11-A12) der Messschaltung (20) angeschlossen sind und mit ihrem zweiten Anschluss (31b, 32b) jeweils an eine der zweiten Anschlusskontaktstellen (A21-A24) der Messschaltung (20) angeschlossen sind, wobei die ersten Anschlüsse (31a, 32a) der Sensorsubeinrichtungen (31, 32) jeweils an unterschiedlichen ersten Anschlusskontaktstellen (A11-A12) und die zweiten Anschlüsse (31b, 32b) der Sensorsubeinrichtungen (31, 32) jeweils an unterschiedlichen zweiten Anschlusskontaktstellen (A21-A24) angeschlossen sind.

## Beschreibung

Die Erfindung bezieht sich auf induktive Sensoreinrichtungen, die mit einer Messschaltung und zumindest einem an die Messschaltung angeschlossenen induktiven Sensorelement ausgestattet sind. Induktive Sensoreinrichtungen dieser Art werden beispielsweise innerhalb von prozesstechnischen Anlagen eingesetzt. Die Sensoreinrichtungen können beispielsweise dazu dienen, Objekte in vordefinierten Detektionszonen zu detektieren und entsprechende Objekterkennungssignale als Messsignale zu erzeugen.

Zur Objekterkennung werden als induktive Sensorelemente häufig Spulen eingesetzt, die ein äußeres Magnetfeld erzeugen, das von im Detektionsbereich der Sensoreinrichtung befindlichen Objekten verändert, insbesondere gedämpft wird, was wiederum durch die Messschaltung der Sensoreinrichtung detektiert wird.

Bei Sensoreinrichtungen mit Messschaltung und daran angeschlossenem induktiven Sensorelement ist problematisch, dass im Falle eines Abrisses oder eines Lösens des elektrischen Anschlusses des Sensorelements von der zugeordneten Messschaltung das Sensorsignal der Sensoreinrichtung fehlerhaft werden kann und beispielsweise ein Zustand angezeigt wird, der für einen Weiterbetrieb gefährlich wäre und/oder die Stromaufnahme der Sensoreinrichtung so stark ansteigt, dass mit der Sensoreinrichtung verbundene weitere externe Schaltungen oder Geräte beschädigt werden.

Der Erfindung liegt somit die Aufgabe zugrunde, eine Sensoreinrichtung anzugeben, bei der im Falle eines Abreißens oder Lösens von elektrischen Anschlüssen des oder der Sensorelemente das Risiko einer gefährlichen Betriebssituation reduziert ist.

Diese Aufgabe wird erfindungsgemäß durch eine induktive Sensoreinrichtung mit den Merkmalen gemäß Patentanspruch 1 gelöst. Vorteilhafte Ausgestaltungen der erfindungsgemäßen Sensoreinrichtung sind in Unteransprüchen angegeben.

Danach ist erfindungsgemäß vorgesehen, dass das Sensorelement zumindest eine erste Sensorsubeinrichtung und eine zweite Sensorsubeinrichtung umfasst, die Messschaltung zwei oder mehr erste Anschlusskontaktstellen, die untereinander kurzgeschlossen sind, und zwei oder mehr zweite Anschlusskontaktstellen, die untereinander kurzgeschlossen sind, aufweist und die Sensorsubeinrichtungen jeweils einen ersten und einen zweiten Anschluss aufweisen, mit ihrem ersten Anschluss jeweils an eine der ersten Anschlusskontaktstellen der Messschaltung angeschlossen sind und mit ihrem zweiten Anschluss jeweils an eine der zweiten Anschlusskontaktstellen der Messschaltung angeschlossen sind, wobei die ersten Anschlüsse der Sensorsubeinrichtungen jeweils an unterschiedlichen ersten Anschlusskontaktstellen und die zweiten Anschlüsse der Sensorsubeinrichtungen jeweils an unterschiedlichen zweiten Anschlusskontaktstellen angeschlossen sind.

Ein wesentlicher Vorteil der erfindungsgemäßen Sensoreinrichtung ist darin zu sehen, dass das Sensorelement zumindest zwei Sensorsubeinrichtungen aufweist, die an individuell zugeordneten Anschlusskontaktstellen mit der Messschaltung verbunden sind. Kommt es zu einem Abreißen bzw. einer elektrischen Trennung einer der Sensorsubeinrichtungen von der zugeordneten Messschaltung, so kann die andere Sensorsubeinrichtung bzw. können die anderen Sensorsubeinrichtungen, die noch mit der Messschaltung verbunden sind, gefährliche Folgen vermeiden: So können die Sensorsubeinrichtungen beispielsweise jeweils derart dimensioniert sein, dass jede für sich allein eine korrekte Funktion der Sensoreinrichtung aufrechterhält und jede jeweils für sich ein korrektes Sensorsignal erzeugen bzw. miterzeugen kann. Alternativ kann vorgesehen sein, dass bei einem Abreißen einer der Sensorsubeinrichtungen die noch vorhandene andere oder anderen Sensorsubeinrichtungen zumindest die Stromaufnahme der Sensoreinrichtung begrenzen bzw. unterhalb oder auf einer vorgegebenen Schwelle halten, um eine Zerstörung daran angeschlossener externer elektrischer Anordnungen zu vermeiden.

Die Messschaltung ist vorzugsweise derart ausgebildet, dass im Fehlerfall - bei einem Abreißen der elektrischen Verbindung zwischen einer der Sensorsubeinrichtungen und der Messschaltung - die verbleibende elektrische Verbindung zwischen der oder den anderen Sensorsubeinrichtungen und der Messschaltung die Stromaufnahme der Sensoreinrichtung auf einer vorgegebenen Schwelle hält. Die Schwelle ist vorzugsweise derart bemessen, dass sie einen Fehler der Sensoreinrichtung nach außen signalisiert, ohne dabei an die Sensoreinrichtung angeschlossene externe elektrische Anordnungen zu gefährden.

Vorteilhaft ist es, wenn die ersten Anschlusskontaktstellen der Messschaltung voneinander räumlich beabstandet sind und die ersten Anschlüsse der Sensorsubeinrichtungen voneinander räumlich beabstandet an unterschiedlichen ersten Anschlusskontaktstellen angeschlossen sind. Ein räumlicher Abstand erleichtert das Anbringen, beispielsweise Anlöten der Anschlüsse an den Anschlusskontaktstellen und reduziert im späteren Betrieb das Risiko eines gleichzeitigen Abreißens.

Entsprechend ist es vorteilhaft, wenn auch die zweiten Anschlusskontaktstellen der Messschaltung voneinander räumlich beabstandet sind und die zweiten Anschlüsse der Sensorsubeinrichtungen voneinander räumlich beabstandet an räumlich unterschiedlichen zweiten Anschlusskontaktstellen angeschlossen sind.

Das zumindest eine induktive Sensorelement bildet vorzugsweise einen Bestandteil eines LC-Resonanzkreises, der von der als Anregeschaltung arbeitenden Messschaltung in eine Schwingung versetzt wird.

Der Strom durch die Messschaltung bildet vorzugsweise ein Sensorsignal der Sensoreinrichtung.

Als besonders vorteilhaft wird es angesehen, wenn das Sensorelement eine Litzenspule aufweist, die eine Litze mit einer Mehrzahl an voneinander elektrisch, insbesondere durch Lackschichten, isolierten Einzeldrähten aufweist, wobei eine erste Untergruppe der Einzeldrähte der Litzespule die erste Sensorsubeinrichtung oder zumindest einen Bestandteil davon bildet und wobei eine zweite Untergruppe der Einzeldrähte der Litzespule die zweite Sensorsubeinrichtung oder zumindest einen Bestandteil davon bildet.

Sensorsubeinrichtungen bzw. Spulen, die durch Untergruppen einer Litze mit jeweils einer Vielzahl an Einzeldrähten gebildet werden, weisen den Vorteil auf, dass sich mit diesen besonders hohe Arbeitsfrequenzen bzw. hohe Oszillationsfrequenzen erreichen lassen. Dies liegt daran, dass der Spulenwiderstand stark von der Frequenz der Oszillation abhängt, der wiederum stark vom Durchmesser des Drahtes bzw. vom Skin-Effekt bestimmt wird. Höhere Frequenzen lassen sich in vorteilhafter Weise erreichen, wenn ein einzelner relativ dicker Draht durch viele parallel geschaltete und gegeneinander isolierte dünne Einzeldrähte ersetzt wird. Darüber hinaus weisen Litzenspulen den Vorteil auf, dass sich im Rahmen eines einzigen Wickelvorgangs mit einer einzigen Litze ein, zwei oder mehr Sensorsubeinrichtungen gleichzeitig bilden lassen.

Bei einer bevorzugten Ausgestaltung ist die Litzenspule spulenträgerfrei und somit besonders leicht.

Bei einer anderen bevorzugten Ausgestaltung weist die Litzenspule einen Spulenträger auf, auf der die Litze aufgewickelt ist. Ein Spulenträger erhöht die mechanische Stabilität des Gesamtsystems.

Bei einer Ausgestaltung mit Litzenspule ist es vorteilhaft, wenn die Einzeldrähte der ersten Untergruppe jeweils mit einem ihrer Drahtenden an den ersten Anschluss der ersten Sensorsubeinrichtung angeschlossen sind oder diesen gemeinsam bilden und mit jeweils dem anderen Drahtende an den zweiten Anschluss der ersten Sensorsubeinrichtung angeschlossen sind oder diesen gemeinsam bilden, und wenn die Einzeldrähte der zweiten Untergruppe jeweils mit einem ihrer Drahtenden an den ersten Anschluss der zweiten Sensorsubeinrichtung angeschlossen sind oder diesen gemeinsam bilden und mit jeweils dem anderen Drahtende an den zweiten Anschluss der zweiten Sensorsubeinrichtung angeschlossen sind oder diesen gemeinsam bilden.

Die Sensoreinrichtung weist vorzugsweise zwei oder mehr Sensorelemente auf, die jeweils zumindest eine erste Sensorsubeinrichtung und eine zweite Sensorsubeinrichtung umfassen und sensorsubeinrichtungsindividuell an die Messschaltung angeschlossen sind.

Bei der letztgenannten Ausgestaltung ist es von Vorteil, wenn zumindest zwei der Sensorelemente jeweils eine Litzenspule aufweisen, die eine Litze mit einer Mehrzahl an voneinander elektrisch, insbesondere durch Lackschichten, isolierten Einzeldrähten aufweist, wobei eine erste Untergruppe der Einzeldrähte der jeweiligen Litzespule die erste Sensorsubeinrichtung des jeweiligen Sensorelements oder zumindest einen Bestandteil davon bildet und wobei eine zweite Untergruppe der Einzeldrähte der jeweiligen Litzespule die zweite Sensorsubeinrichtung des jeweiligen Sensorelements oder zumindest einen Bestandteil davon bildet.

Auch ist es vorteilhaft, wenn die Messschaltung zwei oder mehr dritte Anschlusskontaktstellen aufweist, die untereinander kurzgeschlossen sind und im Falle zweier oder mehr Sensorelemente eines der Sensorelemente an zwei oder mehr der ersten und zwei oder mehr der zweiten Anschlusskontaktstellen angeschlossen ist und ein anderes der Sensorelemente an ein oder mehr derselben zweiten oder anderer zweiter sowie ein oder mehr der dritten Anschlusskontaktstellen angeschlossen ist.

Die dritten Anschlusskontaktstellen liegen vorzugsweise elektrisch auf dem Potential eines der Messanschlüsse der Messschaltung.

Induktive Sensoreinrichtungen der beschriebenen Art können beispielsweise gemäß Namur-Norm ausgeführt werden. Die Namur-Norm sieht vor, dass eine Stromaufnahme kleiner als 1 mA einen gedämpften Zustand des Schwingkreises anzeigt und eine Stromaufnahme größer als 2 mA einen ungedämpften Schwingkreis. Die jeweils anhand der Stromaufnahme festgestellte Bedämpfung des Schwingkreises wird dabei anhand der Stromaufnahme der Sensoreinrichtung festgestellt.

Eine Sensoreinrichtung nach Namur-Norm kann beispielsweise einen LC-Resonanzkreis aufweisen, der durch eine Oszillatorschaltung in Schwingung versetzt wird. Der elektrische Strom durch das induktive Sensorelement kann ein Magnetfeld erzeugen, das die Sensoreinrichtung an seiner empfindlichen Seite bzw. im Bereich einer Detektionszone der Sensoreinrichtung umgibt. Dringt nun ein elektrisch leitfähiges Material in das Magnetfeld ein, entstehen in diesem Wirbelströme, die elektrische Verluste verursachen. Diese Verluste entziehen dem Schwingkreis Energie, sodass die Schwingungsamplitude geringer wird oder die Schwingung sogar ganz zum Erliegen kommt. Die Amplitude kann von der Messschaltung verarbeitet werden, um ausgangsseitig ein entsprechendes Namur-Norm-kompatibles Sensorsignal zu erzeugen.

Die Erfindung bezieht sich darüber hinaus auf ein Verfahren zum Herstellen einer induktiven Sensoreinrichtung, die eine Messschaltung und zumindest ein an diese angeschlossenes induktives Sensorelement umfasst. Erfindungsgemäß ist vorgesehen, dass eine Messschaltung, die zwei oder mehr erste Anschlusskontaktstellen, die untereinander kurzgeschlossen sind, und zwei oder mehr zweite Anschlusskontaktstellen, die untereinander kurzgeschlossen sind, aufweist, hergestellt wird, zur Bildung des induktiven Sensorelements eine erste Sensorsubeinrichtung und eine zweite Sensorsubeinrichtung hergestellt werden, und die Sensorsubeinrichtungen jeweils mit einem Anschluss an eine individuell zugeordnete erste Anschlusskontaktstelle der Messschaltung angeschlossen werden und mit einem zweiten Anschluss jeweils an eine individuell zugeordnete zweite Anschlusskontaktstelle der Messschaltung angeschlossen werden.

Bezüglich der Vorteile und vorteilhafter Ausgestaltungen des erfindungsgemäßen Verfahrens sei auf die obigen Ausführungen im Zusammenhang mit der erfindungsgemäßen Sensoreinrichtung sowie deren vorteilhafter Ausgestaltungen verwiesen.

Vorteilhaft ist es, wenn eine Litze, die aus einer Mehrzahl an voneinander, insbesondere durch Lackschichten, isolierten Einzeldrähten besteht, unter Bildung einer Litzenspule gewickelt wird, mit einer ersten Untergruppe der Einzeldrähte der Litze der Litzenspule die erste Sensorsubeinrichtung gebildet wird und mit einer zweiten Untergruppe der Einzeldrähte der Litze der Litzenspule die zweite Sensorsubeinrichtung gebildet wird.

Auch ist es von Vorteil, wenn die Einzeldrähte der ersten Untergruppe jeweils mit einem ihrer Drahtenden an den ersten Anschluss der ersten Sensorsubeinrichtung angeschlossen werden oder der letztgenannte Anschluss mit diesen Drahtenden gebildet wird und die anderen Drahtenden der Einzeldrähte jeweils an den zweiten Anschluss der ersten Sensorsubeinrichtung angeschlossen werden oder der letztgenannte Anschluss mit den letztgenannten Drahtenden gebildet wird und die Einzeldrähte der zweiten Untergruppe jeweils mit einem ihrer Drahtenden an den ersten Anschluss der zweiten Sensorsubeinrichtung angeschlossen werden oder der letztgenannte Anschluss mit den letztgenannten Drahtenden gebildet wird und die anderen Drahtenden der Einzeldrähte der zweiten Untergruppe jeweils an den zweiten Anschluss der zweiten Sensorsubeinrichtung angeschlossen werden oder der letztgenannte Anschluss mit den letztgenannten Drahtenden gebildet wird.

Bei einer besonders bevorzugten Ausgestaltung ist vorgesehen, dass die Einzeldrähte der ersten Untergruppe jeweils mit einem ihrer Drahtenden mit einem der ersten Anschlusskontaktstellen der Messschaltung verbunden, insbesondere verlötet, werden und die Einzeldrähte der ersten Untergruppe jeweils mit ihrem anderen Drahtende mit einer der zweiten Anschlusskontaktstellen der Messschaltung verbunden, insbesondere verlötet, werden und die Einzeldrähte der zweiten Untergruppe jeweils mit einem ihrer Drahtenden mit einer anderen ersten Anschlusskontaktstelle der Messschaltung verbunden, insbesondere verlötet, werden und die Einzeldrähte der zweiten Untergruppe jeweils mit ihrem anderen Drahtende mit einer anderen zweiten Anschlusskontaktstelle der Messschaltung verbunden, insbesondere verlötet, werden.

Die Erfindung wird nachfolgend anhand von Ausführungsbeispielen näher erläutert; dabei zeigen beispielhaft
- Figur 1: ein Ausführungsbeispiel für eine induktive Sensoreinrichtung, die zwei Sensorelemente mit jeweils zwei Sensorsubeinrichtungen umfasst, wobei allen Sensorsubeinrichtungen jeweils eigene Anschlusskontakte zugeordnet sind,
- Figur 2: ein Ausführungsbeispiel für ein Sensorelement mit zwei Sensorsubeinrichtungen für die induktive Sensoreinrichtung gemäß den Figuren 1 und 3 bis 7,
- Figur 3: ein Ausführungsbeispiel für eine induktive Sensoreinrichtung, die zwei Sensorelemente mit jeweils zwei Sensorsubeinrichtungen umfasst, wobei sich Sensorsubeinrichtungen Anschlusskontakte teilen,
- Figur 4: ein Ausführungsbeispiel für eine induktive Sensoreinrichtung, die ein Sensorelement mit zwei Sensorsubeinrichtungen und ein weiteres Sensorelement, das durch eine einzige Spule gebildet ist, umfasst,
- Figur 5: ein weiteres Ausführungsbeispiel für eine induktive Sensoreinrichtung, die ein Sensorelement mit zwei Sensorsubeinrichtungen und ein weiteres Sensorelement, das durch eine einzige Spule gebildet ist, umfasst,
- Figur 6: ein Ausführungsbeispiel für eine induktive Sensoreinrichtung, die nur ein einziges Sensorelement umfasst und
- Figur 7: ein Ausführungsbeispiel für eine induktive Sensoreinrichtung ohne optische Anzeigeeinrichtung.

In den Figuren werden der Übersicht halber für identische oder vergleichbare Komponenten stets dieselben Bezugszeichen verwendet.

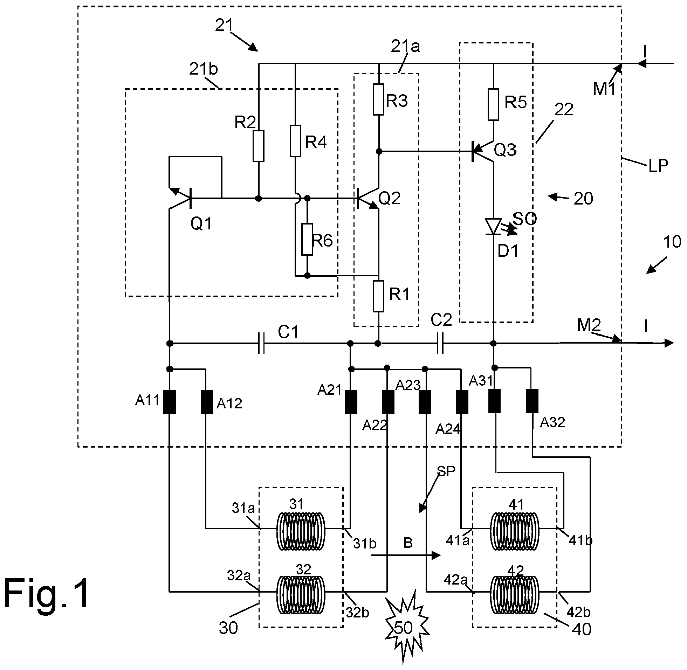

Die Figur 1 zeigt ein Ausführungsbeispiel für eine induktive Sensoreinrichtung 10, die eine Messschaltung 20 und ein daran angeschlossenes induktives Sensorelement 30 umfasst.

Die Messschaltung 20 weist bei dem Ausführungsbeispiel gemäß Figur 1 eine Oszillatorschaltung 21, eine optische Anzeigeeinrichtung 22, zwei Kondensatoren C1 und C2, eine Leiterplatte LP und auf der Leiterplatte LP aufgebrachte Anschlusskontaktstellen A11-A12, A21-A24, A31-A32 auf.

Die Oszillatorschaltung 21 besteht aus einer Verstärkerschaltung 21a, deren Arbeitspunkt mittels einer Arbeitspunkteinstellschaltung 21b eingestellt wird.

Die Verstärkerschaltung 21a umfasst bei dem Ausführungsbeispiel gemäß Figur 1 einen Transistor Q2 und zwei elektrische Widerstände R1 und R3. Die Arbeitspunkteinstellschaltung 21b umfasst bei dem Ausführungsbeispiel gemäß Figur 1 einen Transistor Q1 (der hier beispielsweise als Diode verwendet wird) und drei Widerstände R2, R4 und R6. Die Anzeigeeinrichtung 22 umfasst bei dem Ausführungsbeispiel gemäß Figur 1 einen Transistor Q3, einen Vorwiderstand R5 sowie eine Leuchtdiode D1.

Die Leuchtdiode D1 dient zur Ausgabe eines optischen Sensorsignals SO der Sensoreinrichtung 10. Ein elektrisches Sensorsignal der Sensoreinrichtung 10 wird durch die Stromaufnahme bzw. den Strom I gebildet, der in die Messschaltung 20 an einem Messanschluss M1 hineinfließt und an einem anderen Messanschluss M2 wieder herausfließt.

Die Messschaltung 20 ist vorzugsweise auf der Leiterplatte LP angeordnet, die bei dem Ausführungsbeispiel gemäß Figur 1 zwei erste Anschlusskontaktstellen A11 und A12, vier zweite Anschlusskontaktstellen A21 bis A24 und zwei dritte Anschlusskontaktstellen A31 und A32 trägt. Die Anschlusskontaktstellen sind vorzugsweise durch Lötflächen gebildet, die ein Anlöten von Anschlussdrähten ermöglicht.

Das Sensorelement 30 umfasst zwei oder mehr Sensorsubeinrichtungen, von denen in der Figur 1 eine erste Sensorsubeinrichtung 31 und eine zweite Sensorsubeinrichtung 32 dargestellt sind.

Die erste Sensorsubeinrichtung 31 ist mit ihrem ersten Anschluss 31a an eine der ersten Anschlusskontaktstellen A12 und mit ihrem zweiten Anschluss 31b an einen der zweiten Anschlusskontaktstellen A21 angeschlossen. Die zweite Sensorsubeinrichtung 32 ist entsprechend mit ihrem ersten Anschluss 32a an eine der ersten Anschlusskontaktstellen A11 und mit ihrem zweiten Anschluss 31b an einen der zweiten Anschlusskontaktstellen A22 angeschlossen.

Der Anschluss der beiden Sensorsubeinrichtungen 31 und 32 erfolgt vorzugsweise durch Anlöten auf den jeweils zugeordneten Anschlusskontaktstellen. Die Anschlusskontaktstellen A11 bis A32 sind auf der Leiterplatte der Sensoreinrichtung 10 vorzugsweise beabstandet zueinander angeordnet, damit jede der Anschlusskontaktstellen individuell verlötet werden kann.

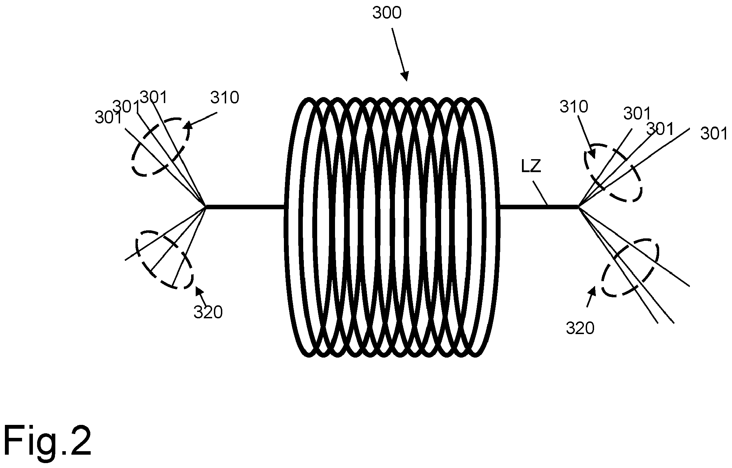

Die beiden Sensorsubeinrichtungen 31 und 32 können jeweils durch individuelle Spulen gebildet werden, die jeweils individuell an die zugeordneten Anschlusskontaktstellen A11, A12, A21 und A22 angelötet werden. Besonders vorteilhaft ist es jedoch, wenn - wie in der Figur 2 beispielhaft gezeigt ist - die beiden Subeinrichtungen 31 und 32 durch eine gemeinsame Litzenspule 300 gebildet werden, die eine Litze LZ mit einer Mehrzahl voneinander elektrisch, insbesondere durch Lackschichten, isolierten Einzeldrähten 301 aufweist. Eine erste Untergruppe 310 der Einzeldrähte 301 der Litzenspule 300 bildet vorzugsweise die erste Sensorsubeinrichtung 31 gemäß Figur 1. Eine zweite Untergruppe 320 der Einzeldrähte 301 der Litzenspule 300 bildet vorzugsweise die zweite Sensorsubeinrichtung 32 gemäß Figur 1.

Die Litzenspule 300 kann spulenträgerfrei hergestellt und lediglich mit Luft gefüllt sein; eine solche selbsttragende, spulenkörperfreie Litzenspule 300 kann in vorteilhafter Weise mit einer Litze LZ hergestellt werden, deren äußere Mantelisolation (nicht die Isolation der Einzeldrähte 301) aus einem sogenannten Backlackdraht besteht. Dies ermöglicht es beispielsweise, während und/oder nach dem Wickeln der Litzenspule 300 die Wicklungen untereinander zu verkleben, sei es durch Aufbringen eines externen Klebstoffes und/oder durch Heißkleben bzw. "Verbacken" von Mantelmaterial des aufgewickelten Spulendrahtes und/oder durch Behandlung mit einem Lösungsmittel.

Die isolierten Einzeldrähte 301 der Litzenspule 300 bestehen vorzugsweise aus einem gegenüber der äußeren Mantelisolation temperatur- und/oder lösungsmittelbeständigen Material, das bei einem Verbacken und/oder Anlösen der äußere Mantelisolation unbeschädigt bleibt.

Alternativ kann die Litze LZ auch auf einem Träger aufgewickelt sein, der in der Figur 2 aus Gründen der Übersicht nicht weiter dargestellt ist.

Sensorsubeinrichtungen bzw. Spulen, die durch Untergruppen einer Litze LZ mit jeweils einer Vielzahl an Einzeldrähten 301 gebildet werden, weisen den Vorteil auf, dass sich mit diesen besonders hohe Arbeitsfrequenzen bzw. Oszillationsfrequenzen der Sensoreinrichtung 10 erreichen lassen; denn der Spulenwiderstand hängt stark von der Frequenz ab, der wiederum stark vom Durchmesser des Drahtes abhängt. Höhere Frequenzen lassen sich in vorteilhafter Weise erreichen, wenn ein einzelner relativ dicker Draht durch viele parallel geschaltete und gegeneinander isolierte dünne Einzeldrähte 301, also "HF-Einzeldrähte", ersetzt wird, wie dies in der Figur 2 gezeigt ist.

Darüber hinaus weist die in der Figur 2 gezeigte Ausgestaltung der Sensorsubeinrichtungen den Vorteil auf, dass sich im Rahmen eines einzigen Wickelvorgangs mit einer einzigen Litze LZ ein, zwei oder mehr Sensorsubeinrichtungen gleichzeitig bilden lassen.

Bei dem Ausführungsbeispiel gemäß Figur 1 weist die induktive Sensoreinrichtung 10 neben dem Sensorelement 30 ein weiteres Sensorelement 40 auf, das zwei oder mehr Sensorsubeinrichtungen umfasst, von denen in der Figur 1 eine erste Sensorsubeinrichtung 41 und eine zweite Sensorsubeinrichtung 42 dargestellt sind.

Die erste Sensorsubeinrichtung 41 ist mit ihrem ersten Anschluss 41a an eine der zweiten Anschlusskontaktstellen A24 und mit ihrem zweiten Anschluss 41b an einen der dritten Anschlusskontaktstellen A31 angeschlossen. Die zweite Sensorsubeinrichtung 42 ist entsprechend mit ihrem ersten Anschluss 42a an eine der zweiten Anschlusskontaktstellen A23 und mit ihrem zweiten Anschluss 41b an einen der dritten Anschlusskontaktstellen A32 angeschlossen. Die dritten Anschlusskontaktstellen A31 und A32 liegen elektrisch auf dem Potential eines der Messanschlüsse M1 oder M2 der Messschaltung 20, hier auf dem Potential des Messanschlusses M2.

Der Anschluss der beiden Sensorsubeinrichtungen 41 und 42 erfolgt vorzugsweise durch Anlöten auf den jeweils zugeordneten Anschlusskontaktstellen.

Die beiden Sensorsubeinrichtungen 41 und 42 können jeweils durch individuelle Spulen gebildet werden, die jeweils individuell an die zugeordneten Anschlusskontaktstellen A23, A24, A31 und A32 angelötet werden. Besonders vorteilhaft ist es jedoch, wenn die beiden Sensorsubeinrichtungen 41 und 42 durch eine gemeinsame Litzenspule 300 gebildet werden, wie sie in der Figur 2 gezeigt ist; diesbezüglich gelten die obigen Ausführungen im Zusammenhang mit der Figur 1 entsprechend.

Die beiden Sensorelemente 30 und 40 können beispielsweise baugleich sein.

Vorteilhaft ist es, wenn die beiden Sensorelemente 30 und 40 hinsichtlich der Anordnung ihrer Spulenachse koaxial angeordnet sind, sodass der magnetische Fluss B beide Sensorelemente 30 und 40 in vergleichbarer Form durchsetzt. Der in der Figur 1 dargestellte Spalt SP zwischen den beiden Sensorelementen 30 und 40 kann somit eine Detektionszone für ein Objekt 50 bilden, das in den Spalt SP zwischen den beiden Sensorelementen 30 und 40 eindringen kann. Ist beispielsweise ein elektrisch leitfähiges Objekt 50 im Spalt SP vorhanden, so wird durch Wirbelströme im Objekt 50 das Magnetfeld zwischen den beiden Sensorelementen 30 und 40 beeinträchtigt bzw. gedämpft, sodass auch die elektrische Schwingung in dem durch die beiden Kondensatoren C1 und C2 und die beiden Sensorelemente 30 und 40 gebildeten LC-Resonanzkreis gedämpft wird. Der Umfang der Dämpfung beeinflusst sowohl den Strom durch die Leuchtdiode D1 als auch den Strom I, der in die Sensoreinrichtung 10 hineinfließt. Der elektrische Strom I und das optische Sensorsignal SO, also die optische Anzeige, können somit als Detektionssignal zum Detektieren eines Objekts 50 im Spalt SP herangezogen werden.

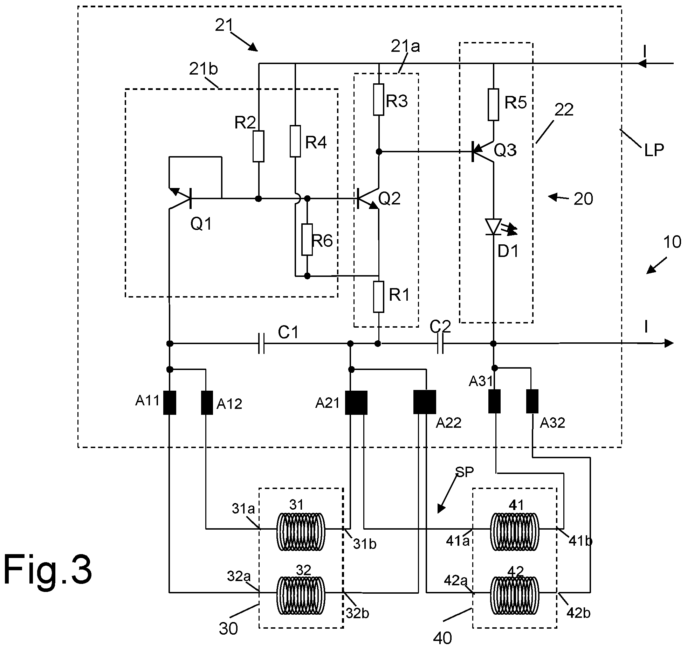

Bei dem Ausführungsbeispiel gemäß Figur 1 sind die Sensorsubeinrichtungen der beiden Sensorelemente 30 und 40 jeweils an individuell zugeordnete Anschlusskontaktstellen der Sensoreinrichtung 20 angelötet. Alternativ kann vorgesehen sein, dass die Sensorsubeinrichtungen des weiteren Subelements 40 an Anschlusskontaktstellen angelötet werden, die auch von Anschlüssen der Sensorsubeinrichtungen 31 und 32 des Sensorelements 30 genutzt werden. Dies zeigt beispielhaft die Figur 3.

Bei dem Ausführungsbeispiel gemäß Figur 3 ist eine der zweiten Anschlusskontaktstellen A21 sowohl vom zweiten Anschluss 31b der ersten Sensorsubeinrichtung 31 des einen Sensorelements 30 als auch vom ersten Anschluss 41a der ersten Sensorsubeinrichtung 41 des weiteren Sensorelements 40 belegt. Eine andere zweite Anschlusskontaktstelle A22 ist sowohl vom zweiten Anschluss 32b der zweiten Sensorsubeinrichtung 32 des einen Sensorelements 30 als auch vom ersten Anschluss 42a der zweiten Sensorsubeinrichtung 42 des weiteren Sensorelements 40 belegt.

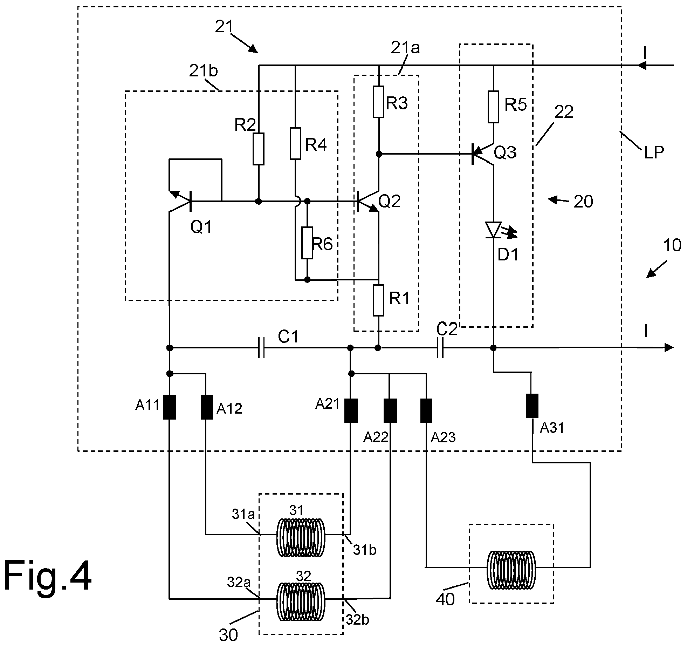

Bei dem Ausführungsbeispiel gemäß den Figuren 1 und 2 sind beide Sensorelemente 30 und 40 jeweils mit zwei Sensorsubeinrichtungen in Form von Spulen ausgestattet. Alternativ kann das weitere Sensorelement 40 auch nur durch eine einzige Spule gebildet sein, wie Figur 4 zweigt.

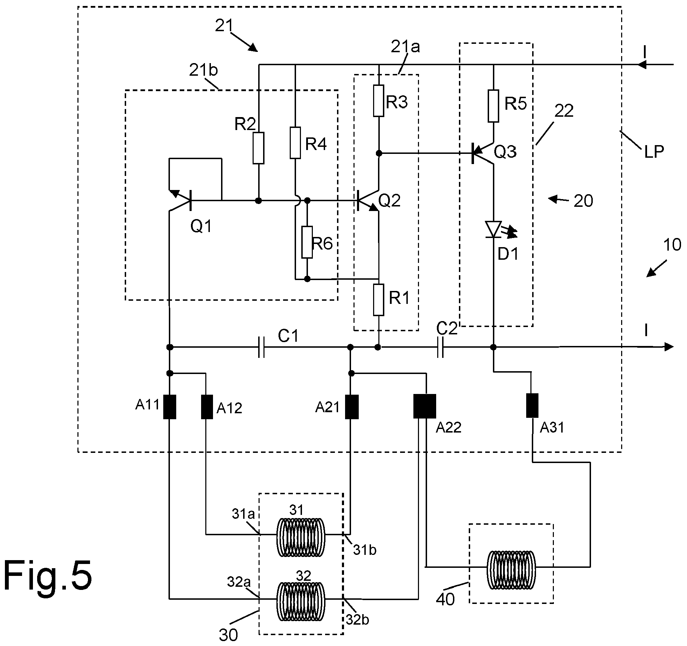

Auch bei der letztgenannten Variante können sich die Sensorelemente 30 und 40 die zweite Anschlusskontaktstelle A22 teilen, wie die Figur 5 zeigt.

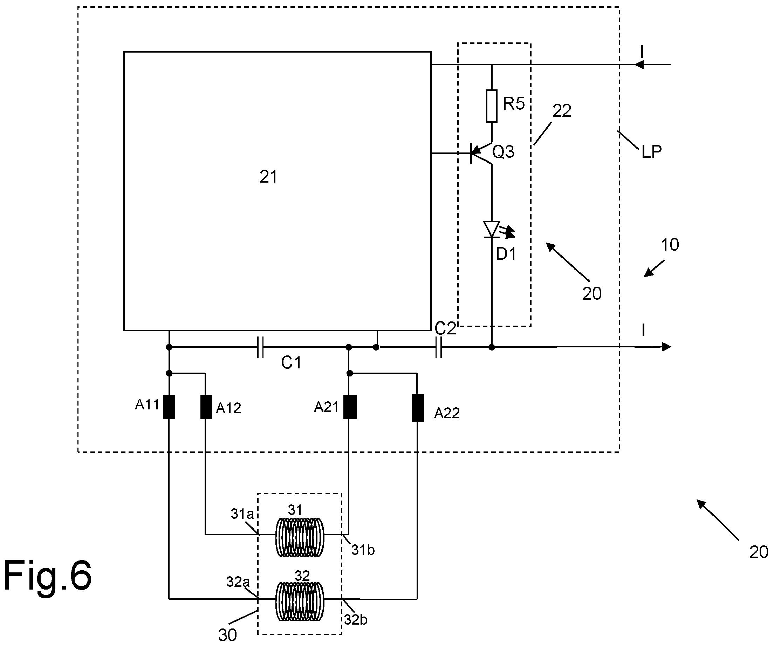

Bei den Ausführungsbeispielen gemäß den Figuren 1 und 3 bis 5 und 7 übt das weitere Sensorelement 40 eine Doppelfunktion aus; denn es erzeugt sowohl ein Magnetfeld zur Objekterkennung als auch eine elektrische Rückkopplung, die eine Oszillation auch für eine Verstärkerschaltung 21a ermöglicht, deren Verstärkung kleiner als 1 ist. Alternativ kann auch nur ein einziges Sensorelement 30 vorhanden sein, wenn die Verstärkerschaltung der Oszillatorschaltung 21 eine Verstärkung von mehr als 1 aufweist. Eine solche Ausgestaltung zeigt beispielhaft die Figur 6.

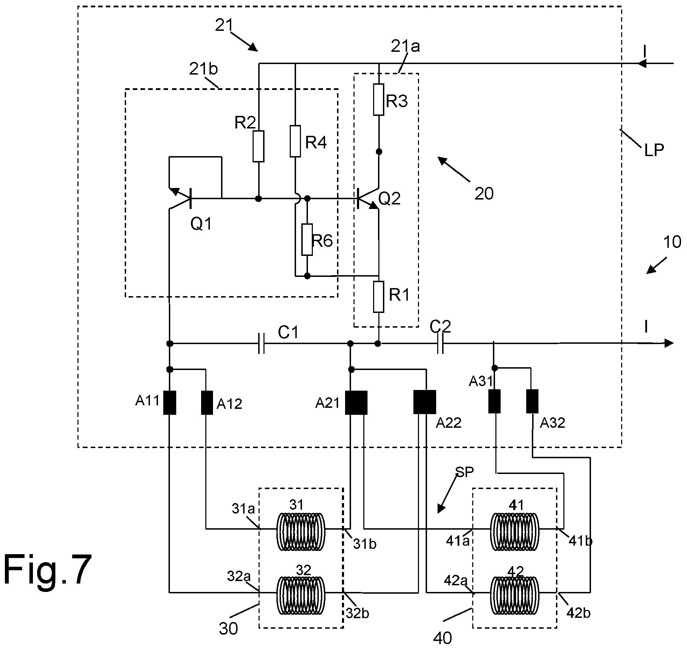

Bei den Ausführungsbeispielen gemäß den Figuren 1 und 3 bis 6 kann die Anzeigeeinrichtung 22 auch ersatzlos fehlen; dies zeigt die Figur 7 beispielhaft anhand des Ausführungsbeispiels gemäß Figur 3.

Induktive Sensoreinrichtungen 10 der oben beschriebenen Art können beispielsweise gemäß Namur-Norm ausgeführt werden. Die Namur-Norm sieht vor, dass eine Stromaufnahme kleiner als 1 mA einen gedämpften Zustand des Schwingkreises anzeigt und eine Stromaufnahme I größer als 2 mA einen ungedämpften Schwingkreis. Die jeweils anhand der Stromaufnahme I festgestellte Bedämpfung des Schwingkreises wird dabei anhand der Stromaufnahme I der Sensoreinrichtung festgestellt.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

### Bezugszeichenliste

- 10: Sensoreinrichtung
- 20: Messschaltung
- 21: Oszillatorschaltung
- 21a: Verstärkerschaltung
- 21b: Arbeitspunkteinstellschaltung
- 22: optische Anzeigeeinrichtung
- 30: Sensorelement
- 31: erste Sensorsubeinrichtung
- 31a: erster Anschluss
- 31b: zweiter Anschluss
- 32: zweite Sensorsubeinrichtung
- 32a: erster Anschluss
- 32b: zweiter Anschluss
- 40: weiteres Sensorelement
- 41: erste Sensorsubeinrichtung
- 41a: erster Anschluss
- 41b: zweiter Anschluss
- 42: zweite Sensorsubeinrichtung
- 50: Objekt
- 300: Litzenspule
- 301: Einzeldrähte
- 310: erste Untergruppe
- 320: zweite Untergruppe

- A11-A12: Anschlusskontaktstellen
- A21-A24: Anschlusskontaktstellen
- A31-A32: Anschlusskontaktstellen
- B: magnetischer Fluss
- C1: Kondensator
- C2: Kondensator
- D1: Leuchtdiode
- I: Strom
- LP: Leiterplatte
- LZ: Litze
- M1: Messanschluss
- M2: Messanschluss
- Q1-Q3: Transistoren
- R1-R4: Widerstände
- R5: Vorwiderstand
- R6: Widerstand
- SO: Sensorsignal
- SP: Spalt

## Patentansprüche

1. Induktive Sensoreinrichtung (10) mit einer Messschaltung (20) und zumindest einem an dieser angeschlossenen induktiven Sensorelement (30),
**dadurch gekennzeichnet, dass**
- das Sensorelement (30) zumindest eine erste Sensorsubeinrichtung (31) und eine zweite Sensorsubeinrichtung (32) umfasst,
- die Messschaltung (20) zwei oder mehr erste Anschlusskontaktstellen (A11-A12), die untereinander kurzgeschlossen sind, und zwei oder mehr zweite Anschlusskontaktstellen (A21-A24), die untereinander kurzgeschlossen sind, aufweist und
- die Sensorsubeinrichtungen (31, 32) jeweils einen ersten und einen zweiten Anschluss (31a, 31b, 32a, 32b) aufweisen, mit ihrem ersten Anschluss (31a, 32a) jeweils an eine der ersten Anschlusskontaktstellen (A11-A12) der Messschaltung (20) angeschlossen sind und mit ihrem zweiten Anschluss (31b, 32b) jeweils an eine der zweiten Anschlusskontaktstellen (A21-A24) der Messschaltung (20) angeschlossen sind,
- wobei die ersten Anschlüsse (31a, 32a) der Sensorsubeinrichtungen (31, 32) jeweils an unterschiedlichen ersten Anschlusskontaktstellen (A11-A12) und die zweiten Anschlüsse (31b, 32b) der Sensorsubeinrichtungen (31, 32) jeweils an unterschiedlichen zweiten Anschlusskontaktstellen (A21-A24) angeschlossen sind.

2. Sensoreinrichtung (10) nach Anspruch 1,
**dadurch gekennzeichnet, dass**
die Messschaltung (20) derart ausgebildet ist, dass im Fehlerfall - bei einem Abreißen der elektrischen Verbindung zwischen einer der Sensorsubeinrichtungen (31, 32) und der Messschaltung (20) - die verbleibende elektrische Verbindung zwischen der anderen Sensorsubeinrichtung und der Messschaltung (20) die Stromaufnahme (I) der Sensoreinrichtung (10) auf einer vorgegebenen Schwelle hält.

3. Sensoreinrichtung (10) nach einem der voranstehenden Ansprüche,
**dadurch gekennzeichnet, dass**
- die ersten Anschlusskontaktstellen der Messschaltung (20) voneinander räumlich beabstandet sind und die ersten Anschlüsse der Sensorsubeinrichtungen (31, 32) voneinander räumlich beabstandet an unterschiedlichen ersten Anschlusskontaktstellen angeschlossen sind und
- die zweiten Anschlusskontaktstellen der Messschaltung (20) voneinander räumlich beabstandet sind und die zweiten Anschlüsse der Sensorsubeinrichtungen (31, 32) voneinander räumlich beabstandet an räumlich unterschiedlichen zweiten Anschlusskontaktstellen angeschlossen sind.

4. Sensoreinrichtung (10) nach einem der voranstehenden Ansprüche,
**dadurch gekennzeichnet, dass**
- das zumindest eine induktive Sensorelement (30) einen Bestandteil eines LC-Resonanzkreises bildet, der von der als Anregeschaltung arbeitenden Messschaltung (20) in eine Schwingung versetzt wird, und
- der Strom (I) durch die Messschaltung (20) ein Sensorsignal (SO) der Sensoreinrichtung (10) bildet.

5. Sensoreinrichtung (10) nach einem der voranstehenden Ansprüche,
**dadurch gekennzeichnet, dass**
- das Sensorelement (30) eine Litzenspule (300) aufweist, die eine Litze (LZ) mit einer Mehrzahl an voneinander elektrisch, insbesondere durch Lackschichten, isolierten Einzeldrähten (301) aufweist,
- wobei eine erste Untergruppe (310) der Einzeldrähte (301) der Litzenspule (300) die erste Sensorsubeinrichtung (31) oder zumindest einen Bestandteil davon bildet und
- wobei eine zweite Untergruppe (320) der Einzeldrähte (301) der Litzenspule (300) die zweite Sensorsubeinrichtung (32) oder zumindest einen Bestandteil davon bildet.

6. Sensoreinrichtung (10) nach einem der voranstehenden Ansprüche,
**dadurch gekennzeichnet, dass**
die Litzenspule (300) spulenträgerfrei ist.

7. Sensoreinrichtung (10) nach einem der voranstehenden Ansprüche,
**dadurch gekennzeichnet, dass**
die Litzenspule (300) einen Spulenträger aufweist, auf der die Litze (LZ) aufgewickelt ist.

8. Sensoreinrichtung (10) nach einem der voranstehenden Ansprüche,
**dadurch gekennzeichnet, dass**
- die Einzeldrähte (301) der ersten Untergruppe (310) jeweils mit einem ihrer Drahtenden an den ersten Anschluss (31a) der ersten Sensorsubeinrichtung (31) angeschlossen sind oder diesen gemeinsam bilden und mit jeweils dem anderen Drahtende an den zweiten Anschluss (31b) der ersten Sensorsubeinrichtung (31) angeschlossen sind oder diesen gemeinsam bilden, und
- die Einzeldrähte (301) der zweiten Untergruppe (320) jeweils mit einem ihrer Drahtenden an den ersten Anschluss (32a) der zweiten Sensorsubeinrichtung (32) angeschlossen sind oder diesen gemeinsam bilden und mit jeweils dem anderen Drahtende an den zweiten Anschluss (32b) der zweiten Sensorsubeinrichtung (32) angeschlossen sind oder diesen gemeinsam bilden.

9. Sensoreinrichtung (10) nach einem der voranstehenden Ansprüche,
**dadurch gekennzeichnet, dass**
- die Sensoreinrichtung (10) zwei oder mehr Sensorelemente (30, 40) aufweist, die jeweils zumindest eine erste Sensorsubeinrichtung (31, 41) und eine zweite Sensorsubeinrichtung (32, 42) umfassen und sensorsubeinrichtungsindividuell an die Messschaltung (20) angeschlossen sind.

10. Sensoreinrichtung (10) nach Anspruch 9,
**dadurch gekennzeichnet, dass**
- zumindest zwei der Sensorelemente (30, 40) jeweils eine Litzenspule (300) aufweisen, die eine Litze (LZ) mit einer Mehrzahl an voneinander elektrisch, insbesondere durch Lackschichten, isolierten Einzeldrähten (301) aufweist,
- wobei eine erste Untergruppe (310) der Einzeldrähte (301) der jeweiligen Litzenspule (300) die erste Sensorsubeinrichtung (31, 41) des jeweiligen Sensorelements oder zumindest einen Bestandteil davon bildet und
- wobei eine zweite Untergruppe (320) der Einzeldrähte (301) der jeweiligen Litzenspule (300) die zweite Sensorsubeinrichtung (32, 42) des jeweiligen Sensorelements oder zumindest einen Bestandteil davon bildet.

11. Sensoreinrichtung (10) nach Anspruch 10,
**dadurch gekennzeichnet, dass**
- die Messschaltung (20) zwei oder mehr dritte Anschlusskontaktstellen (A31-A32) aufweist, die untereinander kurzgeschlossen sind und
- im Falle zweier oder mehr Sensorelemente eines der Sensorelemente an zwei oder mehr der ersten und zwei oder mehr der zweiten Anschlusskontaktstellen angeschlossen ist und ein anderes der Sensorelemente an ein oder mehr derselben zweiten oder anderer zweiter sowie ein oder mehr der dritten Anschlusskontaktstellen angeschlossen ist,
- wobei die dritten Anschlusskontaktstellen elektrisch auf dem Potential eines der Messanschlüsse der Messschaltung (20) liegen.

12. Verfahren zum Herstellen einer induktiven Sensoreinrichtung (10), die eine Messschaltung (20) und zumindest ein an diese angeschlossenes induktives Sensorelement (30) umfasst, **dadurch gekennzeichnet, dass**
- eine Messschaltung (20), die zwei oder mehr erste Anschlusskontaktstellen (A11-A12), die untereinander kurzgeschlossen sind, und zwei oder mehr zweite Anschlusskontaktstellen (A21-A24), die untereinander kurzgeschlossen sind, aufweist, hergestellt wird,
- zur Bildung des induktiven Sensorelements eine erste Sensorsubeinrichtung (31) und eine zweite Sensorsubeinrichtung (32) hergestellt werden, und
- die Sensorsubeinrichtungen (31, 32) jeweils mit einem Anschluss an eine individuell zugeordnete erste Anschlusskontaktstelle der Messschaltung (20) angeschlossen werden und mit einem zweiten Anschluss jeweils an eine individuell zugeordnete zweite Anschlusskontaktstelle der Messschaltung (20) angeschlossen werden.

13. Verfahren nach Anspruch 12,
**dadurch gekennzeichnet, dass**
- eine Litze (LZ), die aus einer Mehrzahl an voneinander, insbesondere durch Lackschichten, isolierten Einzeldrähten (301) besteht, unter Bildung einer Litzenspule (300) gewickelt wird,
- mit einer ersten Untergruppe (310) der Einzeldrähte (301) der Litze (LZ) der Litzenspule (300) die erste Sensorsubeinrichtung (31) gebildet wird und
- mit einer zweiten Untergruppe (320) der Einzeldrähte (301) der Litze (LZ) der Litzenspule (300) die zweite Sensorsubeinrichtung (32) gebildet wird.

14. Verfahren nach einem der voranstehenden Ansprüche 12 bis 13,
**dadurch gekennzeichnet, dass**
- die Einzeldrähte (301) der ersten Untergruppe (310) jeweils mit einem ihrer Drahtenden an den ersten Anschluss der ersten Sensorsubeinrichtung (31) angeschlossen werden oder der letztgenannte Anschluss mit diesen Drahtenden gebildet wird und die anderen Drahtenden der Einzeldrähte (301) jeweils an den zweiten Anschluss der ersten Sensorsubeinrichtung (31) angeschlossen werden oder der letztgenannte Anschluss mit den letztgenannten Drahtenden gebildet wird und
- die Einzeldrähte (301) der zweiten Untergruppe (320) jeweils mit einem ihrer Drahtenden an den ersten Anschluss der zweiten Sensorsubeinrichtung (32) angeschlossen werden oder der letztgenannte Anschluss mit den letztgenannten Drahtenden gebildet wird und die anderen Drahtenden der Einzeldrähte (301) der zweiten Untergruppe (320) jeweils an den zweiten Anschluss der zweiten Sensorsubeinrichtung (32) angeschlossen werden oder der letztgenannte Anschluss mit den letztgenannten Drahtenden gebildet wird.

15. Verfahren nach einem der voranstehenden Ansprüche 12 bis 14,
**dadurch gekennzeichnet, dass**
- die Einzeldrähte (301) der ersten Untergruppe (310) jeweils mit einem ihrer Drahtenden mit einem der ersten Anschlusskontaktstellen der Messschaltung (20) verbunden, insbesondere verlötet, werden und
- die Einzeldrähte (301) der ersten Untergruppe (310) jeweils mit ihrem anderen Drahtende mit einer der zweiten Anschlusskontaktstellen der Messschaltung (20) verbunden, insbesondere verlötet, werden und
- die Einzeldrähte (301) der zweiten Untergruppe (320) jeweils mit einem ihrer Drahtenden mit einer anderen ersten Anschlusskontaktstelle der Messschaltung (20) verbunden, insbesondere verlötet, werden und
- die Einzeldrähte (301) der zweiten Untergruppe (320) jeweils mit ihrem anderen Drahtende mit einer anderen zweiten Anschlusskontaktstelle der Messschaltung (20) verbunden, insbesondere verlötet, werden.
